# EUROPEAN PATENT APPLICATION

(11) **EP 4 380 337 A1**
(43) Date of publication of application: **05.06.2024**
(21) Application number: 21819016.3
(22) Date of filing: 03.08.2021
(51) Int. Cl.: H10K 50/00

(54) **PACKAGING STRUCTURE, DISPLAY PANEL, AND METHOD FOR MANUFACTURING DISPLAY PANEL**

(30) Priority: 27.07.2021 CN 202110847538
(71) Applicant: Shenzhen China Star Optoelectronics Semiconductor Display Technology Co., Ltd., Shenzhen, Guangdong 518132 (CN)
(72) Inventor: MIAO, Yang, Guangdong 518132 (CN)
(74) Representative: Ström & Gulliksson AB
(86) International application number: PCT/CN2021/110221
(87) International publication number: WO 2023/004839

(57) **Abstract**

A package structure (10), a display panel (100), and a manufacturing method of the display panel (100) are provided. The package structure (10) includes an organic structural layer (101). The organic structural layer (101) obtains a material having organic properties by a manufacturing method of inorganic materials, thereby obtaining an organic structural material having water and oxygen blocking effects of the inorganic materials and buffering properties of organic materials. Therefore, the package structure (10) of the present disclosure can obtain a better encapsulation effect, thereby improving encapsulation reliability of the display panel (100).

## Description

### FIELD OF INVENTION

The present disclosure relates to the field of display technologies, and more particularly, to a package structure, a display panel, and a manufacturing method of the display panel.

### BACKGROUND OF INVENTION

Organic light-emitting diode (OLED) displays have characteristics of self-illumination and do not require backlight sources. In addition, the OLED displays have advantages of high contrast, wide color gamuts, thin thicknesses, fast response times, and being able to be applied to flexible panels. However, since OLED devices are sensitive to water and oxygen, in order to realize effective applications of the OLED displays, OLEDs require to be effectively encapsulated. Thin-film encapsulation is a commonly used effective encapsulation method.

During research and practice of current technology, the inventor of the present application finds that in thin-film package structures, an organic layer is usually manufactured by ink-jet printing after an inorganic thin film is deposited. It is necessary to transfer substrates many times during processes in this kind of package structure. In addition, using a method of ink-jet printing is prone to cause the organic layer to overflow, thereby affecting encapsulation effects.

Technical problem: an embodiment of the present disclosure provides a package structure, a display panel, and a manufacturing method of the display panel to improve the encapsulation effects.

### SUMMARY OF INVENTION

An embodiment of the present disclosure provides a package structure, which includes an organic structural layer, wherein, a material of the organic structural layer includes an organic structural material, and a structural formula of the organic structural material includes 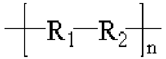 , wherein, an R₁ group is 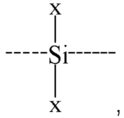 an R₂ group is one or more of 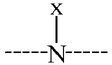 or -----O-----, n is a positive integer greater than or equal to 1, and x is one or more of -----H, ----SiH_{3,} or ---NH_{2.}

Optionally, in some embodiments of the present disclosure, the material of the organic structural layer further includes an inorganic material, the inorganic material includes one or more combinations of silicon nitride, silicon oxide, or silicon oxynitride, and in the organic structural layer, a ratio of a content of the organic structural material to a content of the inorganic material ranges from 0.01 to 0.75.

Optionally, in some embodiments of the present disclosure, the ratio of the content of the organic structural material to the content of the inorganic material ranges from 0.05 to 0.5.

Optionally, in some embodiments of the present disclosure, a thickness of the organic structural layer ranges from 1 µm to 5 µm.

Optionally, in some embodiments of the present disclosure, the package structure further includes at least one inorganic layer, and a material of the at least one inorganic layer includes one or more combinations of nitride, oxide, or nitrogen oxide.

Optionally, in some embodiments of the present disclosure, a thickness of the at least one inorganic layer ranges from 20 nm to 1500 nm.

Optionally, in some embodiments of the present disclosure, the package structure includes two inorganic layers, and the organic structural layer is disposed between the two inorganic layers.

Optionally, in some embodiments of the present disclosure, the package structure includes three inorganic layers and two organic structural layers, and the three inorganic layers and the two organic structural layers are stacked alternatingly.

Optionally, in some embodiments of the present disclosure, the package structure includes three inorganic layers, the organic structural layer, and an organic layer, the three inorganic layers, the organic structural layer, and the organic layer are stacked in sequence in an order of one of the three inorganic layers, the organic structural layer, another one of the three inorganic layers, the organic layer, and yet another one of the three inorganic layers, and a material of the organic layer includes a UV-sensitive polymer, an epoxy polymer, or an acrylic polymer.

Correspondingly, an embodiment of the present disclosure further provides a display panel, which includes:
an array substrate;
a light-emitting device layer disposed on the array substrate; and
a package structure disposed on one side of the light-emitting device layer away from the array substrate and including an organic structural layer; wherein, a material of the organic structural layer includes an organic structural material, and a structural formula of the organic structural material includes 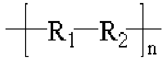 , wherein, an R₁ group is 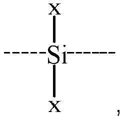 an R₂ group is one or more of 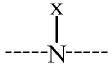 or -----O-----, n is a positive integer greater than or equal to 1, and x is one or more of -----H, ----SiH₃, or ---NH₂.

Optionally, in some embodiments of the present disclosure, the material of the organic structural layer further includes an inorganic material, the inorganic material includes one or more combinations of silicon nitride, silicon oxide, or silicon oxynitride, and in the organic structural layer, a ratio of a content of the organic structural material to a content of the inorganic material ranges from 0.01 to 0.75.

Optionally, in some embodiments of the present disclosure, a thickness of the organic structural layer ranges from 1 µm to 5 µm.

Optionally, in some embodiments of the present disclosure, the package structure further includes at least one inorganic layer, and a material of the at least one inorganic layer includes one or more combinations of nitride, oxide, or nitrogen oxide.

Optionally, in some embodiments of the present disclosure, a thickness of the at least one inorganic layer ranges from 20 nm to 1500 nm.

Optionally, in some embodiments of the present disclosure, the package structure includes two inorganic layers, and the organic structural layer is disposed between the two inorganic layers.

Optionally, in some embodiments of the present disclosure, the package structure includes three inorganic layers and two organic structural layers, and the three inorganic layers and the two organic structural layers are stacked alternatingly.

Optionally, in some embodiments of the present disclosure, the package structure includes three inorganic layers, the organic structural layer, and an organic layer, the three inorganic layers, the organic structural layer, and the organic layer are stacked in sequence in an order of one of the three inorganic layers, the organic structural layer, another one of the three inorganic layers, the organic layer, and yet another one of the three inorganic layers, and a material of the organic layer includes a UV-sensitive polymer, an epoxy polymer, or an acrylic polymer.

Correspondingly, an embodiment of the present disclosure further provides a manufacturing method of a display panel. The method includes following steps:
providing an array substrate;
disposing a light-emitting device layer on the array substrate;
transferring the array substrate provided with the light-emitting device layer into a cavity and introducing reactive gases into the cavity, wherein, the reactive gases include a silane gas and a nitrous oxide gas, or include the silane gas and ammonia;
ionizing the reactive gases to form reactive plasma; and
the reactive plasma undergoing a chemical reaction and being deposited on the light-emitting device layer to form an organic structural layer; wherein, a material of the organic structural layer includes an organic structural material, and a structural formula of the organic structural material includes 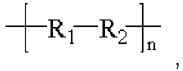 wherein, an R₁ group is 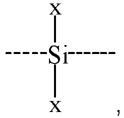 an R₂ group is one or more of 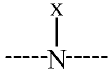 or -----O-----, n is a positive integer greater than or equal to 1, and x is one or more of -----H, ----SiH₃, or ---NH₂.

Optionally, in some embodiments of the present disclosure, after the step of disposing the light-emitting device layer on the array substrate, the method further includes a step of depositing an inorganic layer on one side of the light-emitting device layer away from the array substrate.

Optionally, in some embodiments of the present disclosure, after the step of disposing the light-emitting device layer on the array substrate, the method further includes a step of depositing an organic layer on one side of the inorganic layer away from the array substrate.
Beneficial effect: the embodiments of the present disclosure provide the package structure, the display panel, and the manufacturing method of the display panel. The package structure includes the organic structural layer. The organic structural layer includes the organic structural material. The organic structural material is an inorganic material having chain chemical bonds. Due to having the chain chemical bonds, the inorganic material has related properties of organic materials. For example, the organic structural material has lower stresses and better step-coverage properties. The organic structural layer obtains a material having organic properties by a manufacturing method of inorganic materials, thereby obtaining the organic structural material having water and oxygen blocking effects of the inorganic materials and buffering properties of the organic materials. Therefore, the package structure of the present disclosure can obtain a better encapsulation effect, thereby improving encapsulation reliability of the display panel.

### DESCRIPTION OF DRAWINGS

The accompanying figures to be used in the description of embodiments of the present disclosure will be described in brief to illustrate the technical solutions of the embodiments more clearly. The accompanying figures described below are only part of the embodiments of the present disclosure, from which those skilled in the art can derive further figures without making any inventive efforts.
FIG. 1 is a first schematic structural diagram of a package structure according to an embodiment of the present disclosure.
FIG. 2 is a second schematic structural diagram of the package structure according to an embodiment of the present disclosure.
FIG. 3 is a third schematic structural diagram of the package structure according to an embodiment of the present disclosure.
FIG. 4 is a fourth schematic structural diagram of the package structure according to an embodiment of the present disclosure.
FIG. 5 is a first schematic structural diagram of a display panel according to an embodiment of the present disclosure.
FIG. 6 is a second schematic structural diagram of the display panel according to an embodiment of the present disclosure.
FIG. 7 is a flowchart of a manufacturing method of the display panel according to an embodiment of the present disclosure.

### DETAILED DESCRIPTION OF PREFERRED EMBODIMENTS

The technical solutions in the embodiments of the present disclosure will be clearly and completely described below with reference to the drawings in the embodiments of the present disclosure. Obviously, the described embodiments are only a part of the embodiments of the present disclosure, but not all the embodiments. Based on the embodiments in the present disclosure, all other embodiments obtained by those skilled in the art without creative efforts are within the scope of the present disclosure. In addition, it should be understood that the specific embodiments described herein are only used to illustrate and explain the disclosure and are not used to limit the disclosure. In the present disclosure, in the case of no explanation to the contrary, the orientation words used such as "on" and "under" usually refer to upper and lower directions of the device in actual use or working state, and specifically the directions in the drawings; and "inside" and "outside" refer to the outline of the device.

The embodiments of the present disclosure provide a package structure, a display panel, and a manufacturing method of the display panel. They will be described in detail in the following. It should be noted that an order of description in the following embodiments is not meant to limit a preferred order of the embodiments.

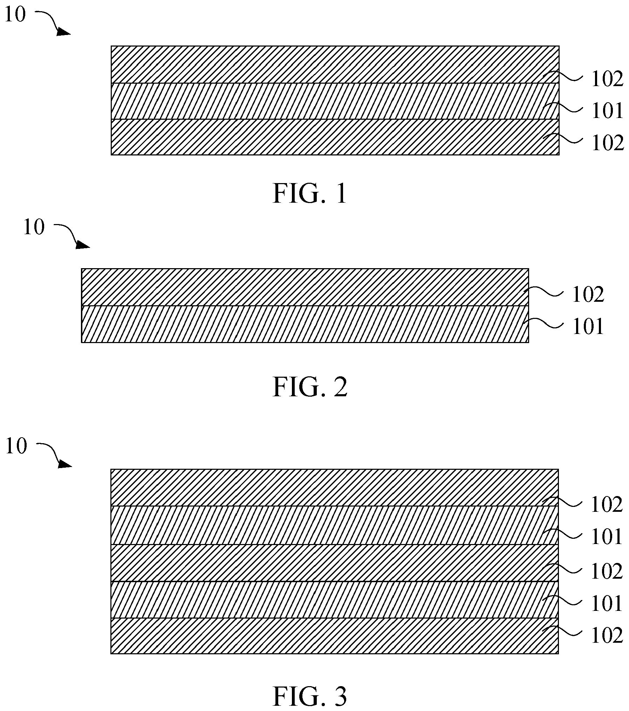

Referring to FIG. 1, FIG. 1 is a first schematic structural diagram of the package structure according to an embodiment of the present disclosure. The present disclosure provides the package structure 10. The package structure 10 includes an organic structural layer 101. A material of the organic structural layer 101 includes an organic structural material, and a structural formula of the organic structural material includes 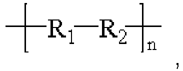 wherein, an R₁ group is 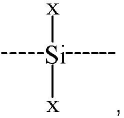 an R₂ group is one or more of 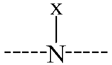 or -----O-----, n is a positive integer greater than or equal to 1, and x is one or more of -----H, ----SiH_{3,} or ---NH_{2.}

The package structure 10 provided in the present disclosure includes the organic structural layer 101. The organic structural layer 101 includes the organic structural material. The organic structural material is an inorganic material having chain chemical bonds. Due to having the chain chemical bonds, the inorganic material has related properties of organic materials. For example, the organic structural material has lower stresses and better step-coverage properties. The organic structural layer 101 of the present disclosure obtains a material having organic properties by a manufacturing method of inorganic materials. Therefore, the organic structural layer 101 has buffering properties of organic encapsulation materials and water and oxygen blocking effects of inorganic encapsulation materials. Therefore, the package structure 10 of the present disclosure can obtain a better encapsulation effect, thereby improving encapsulation reliability of the display panel.

Step coverage means a percentage of ratio of a thickness of a film layer across steps to a thickness of the film layer on a flat place. When a material has better step-coverage properties, the encapsulation effect thereof is better.

Wherein, a thickness of the organic structural layer 101 ranges from 1 µm to 5 µm. Specifically, the thickness of the organic structural layer 101 may be 1 µm, 1.5 µm, 2 µm, 2.5 µm, 3 µm, 3.5 µm, 4 µm, 4.5 µm, or 5 µm. The above numerical values are merely illustrative, and the thickness of the organic structural layer 101 may also be other values from 1 µm to 5 µm. The thickness of the organic structural layer 101 may be set according to encapsulation requirements.

Specifically, in the organic structural material, the R₁ group is 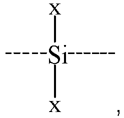 the R₂ group is 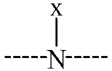 and/or -----O-----, n is the positive integer greater than or equal to 1, and x is one or more of -----H, ----SiH₃, or ---NH₂. That is, x in the R₁ group and the R₂ group may be any one selected from -----H, ----SiH₃, and ---NH₂. The R₂ group may also be -----O-----. Or the R₁ group and the R₂ group in the organic structural material may be two, three, or four kinds selected from the above groups.

For example, in the organic structural material, the R₁ group is --SiH₂--, and the R₂ group is --NH--, then the organic structural material will include a structure of --SiH₂-NH-SiH₂-NH-SiH₂-......NH-SiH₂-NH--. For another example, in the organic structural material, the R₁ group is --Si-- and --SiH₂--, and the R₂ group is --NH--, then the organic structural material may include a structure of --Si-NH-SiH₂-NH-......-Si-NH--. Wherein, another two bond positions of --Simay be connected to one or more of -----H, ----SiH₃, or ---NH₂, and other groups are not completely shown in order to reflect the chain chemical bonds here. The chain structures included in the organic structural material mentioned above are only examples, in fact, the organic structural material of the present disclosure only requires the chain structures formed by inorganic materials, and a specific arrangement thereof is not limited in the present disclosure.

Wherein, the material of the organic structural layer further includes an inorganic material, and the inorganic material includes one or more combinations of silicon nitride, silicon oxide, or silicon oxynitride. The organic structural layer is manufactured by plasma enhanced chemical vapor deposition. Specifically, silane, ammonia, and water are introduced to be as reactive gases, and then the reactive gases are ionized by microwave or radio frequency to locally form plasma. A chemical activity of the plasma is very strong, so it is easy for the plasma to react and then form the organic structural layer. Therefore, when the reactive gases are introduced, a part of the reactive gases will be partially ionized to be 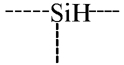 -----SiH₂--, -----SiH₃, > , , 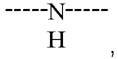 -----NH₂, and -----O----- by microwave or radio frequency. At a same time, another part of the reactive gases will be completely ionized to be 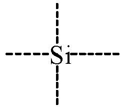 and 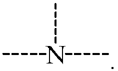 Partial groups mentioned above will form the organic structural material having the chain chemical bonds. Another partial groups that are completely ionized will form the inorganic material, such as silicon nitride, silicon oxide, and silicon oxynitride.

It should be noted that since there is uncertainty for the organic structural material to form bonds after ionized, in addition to the x group mentioned above, the organic structural material may also form a cross-linked structure with peripheral organic structural materials.

Wherein, the organic structural material and the inorganic material that specifically form are related to the reactive gases that are introduced. For example, when silane and ammonia are introduced, the inorganic material that is formed is silicon nitride, and in the organic structural material that is formed, the R₁ group is one or more of 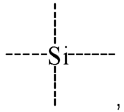 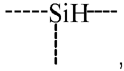 -----SiH₂-- , or -----SiH₃, and the R₂ group is one or more of 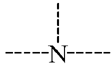 or 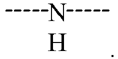 The inorganic material that is formed being silicon oxide and silicon oxynitride and corresponding organic structural material thereof are similar to the above example and will not be repeated here.

Wherein, in the organic structural layer 101, a molar ratio of the organic structural material to the inorganic material ranges from 0.01 to 0.75. Further, the molar ratio of the organic structural material to the inorganic material may range from 0.05 to 0.5. As mentioned above, the organic structural material and the inorganic material are formed by a chemical reaction between different plasma groups that are ionized by microwave or radio frequency. In a case of introducing different gas flow rates, types and numbers of plasma groups generated by ionization will also be different. In general, the molar ratio of the organic structural material to the inorganic material that are generated ranges from 0.01 to 0.75. That is, in the organic structural layer, a content of the organic structural material is 1 % to 75% of a content of the inorganic material.

Specifically, a ratio of the content of the organic structural material to the content of the inorganic material may be 0.01, 0.02, 0.03, 0.04, 0.05, 0.1, 0.15, 0.2, 0.25, 0.3, 0.35, 0.4, 0.45, 0.5, 0.55, 0.6, 0.65, 0.7, or 0.75. The above numerical values are merely illustrative, and the molar ratio of the organic structural material to the inorganic material may also be other values from 0.01 to 0.75. The ratio of the content of the organic structural material to the content of the inorganic material ranging from 0.01 to 0.75 can allow the organic structural layer to have properties of the organic materials and excellent encapsulation properties.

The package structure 10 may only be provided with one organic structural layer 101 for encapsulation. Only the one organic structural layer 101 as the package structure 10 can reduce the thickness of the package structure 10. It can ensure bendability of panels when the organic structural layer 101 is applied to flexible display panels for encapsulation. Meanwhile, since there is only one layer of thin-film structure for encapsulation, the thickness of the package structure 10 is thinner at a bending site of the flexible display panels, thereby effectively reducing a bending radius, narrowing bezels, and preventing film layers from breaking at the bending site.

Referring to FIG. 1, the package structure 10 may also include at least one inorganic layer 102. A material of the at least one inorganic layer 102 includes one or more combinations of nitride, oxide, or nitrogen oxide. Specifically, the nitride may be silicon nitride. The oxide may be aluminum oxide, silicon oxide, titanium oxide, zirconium oxide, or zinc oxide. The nitrogen oxide may be silicon oxynitride. Disposing the at least one inorganic layer 102 in the package structure 10, which combines the inorganic material and the material having the organic properties for encapsulation, can obtain a better encapsulation effect. The at least one inorganic layer 102 is used to block water and oxygen, and with the organic properties of the organic structural layer 101, the organic structural layer 101 is used as an organic layer to extend an intruding path of water vapor. Meanwhile, the organic structural layer 101 has good step-coverage properties and can well cover film layers that need to be encapsulated. Combining the organic structural layer 101 and the at least one inorganic layer 102 can improve an ability of the package structure 10 for blocking water and oxygen, thereby extending a service life of the display panel.

Wherein, a thickness of the at least one inorganic layer 102 ranges from 20 nm to 1500 nm. Specifically, the thickness of the at least one inorganic layer 102 may be 20 nm, 300 nm, 400 nm, 500 nm, 600 nm, 700 nm, 800 nm, 900 nm, 1000 nm, 1100 nm, 1200 nm, 1300 nm, 1400 nm, or 1500 nm. The thickness of the at least one inorganic layer 102 may be adaptively set according to encapsulation requirements. For example, when the organic structural layer 101 needs to be set thinner, the thickness of the at least one inorganic layer 102 may be appropriately increased to ensure the encapsulation effect of the package structure.

In the package structure 10 shown in FIG. 1, the package structure 10 includes two inorganic layers 102. The organic structural layer 101 is disposed between the two organic layers 102. Disposing the organic structural layer 101 between the two organic layers 102 can allow the two inorganic layers 102 to play a role of retaining walls. After the organic structural layer 101 absorbs water and oxygen, the inorganic layers 102 can block water and oxygen in the organic structural layer 101 to form a blocking space for water and oxygen, thereby preventing water and oxygen from intruding. This package structure 10 can further improve the ability for blocking water and oxygen and the encapsulation reliability.

In some embodiments, referring to FIG. 2, FIG. 2 is a second schematic structural diagram of the package structure according to an embodiment of the present disclosure. The package structure 10 shown in FIG. 2 includes one inorganic layer 102. The organic structural layer 101 may be disposed on either side of the inorganic layer 102. Combining the organic structural layer 101 and the inorganic layer 102 for encapsulation can improve the ability of the package structure 10 for blocking water and oxygen.

Referring to FIG. 3, FIG. 3 is a third schematic structural diagram of the package structure according to an embodiment of the present disclosure. The package structure 10 includes three inorganic layers 102 and two organic structural layers 101, and the three inorganic layers 102 and the two organic structural layers 101 are stacked alternatingly.

Since film densities of the organic structural layers 101 and the inorganic layers 102 are not particularly high, multiple layers of the organic structural layers 101 and the inorganic layers 102 being stacked alternatingly for encapsulation can improve a density of the package structure 10, thereby better preventing water and oxygen from intruding. In addition, disposing the two organic structural layers 101 can extend the intruding path of water and oxygen. Similarly, the inorganic layers 102 can block water and oxygen in the organic structural layers 101. Therefore, disposing a five-layered alternating stacked structure of the organic structural layers 101 and the inorganic layers 102 can further improve the encapsulation effect.

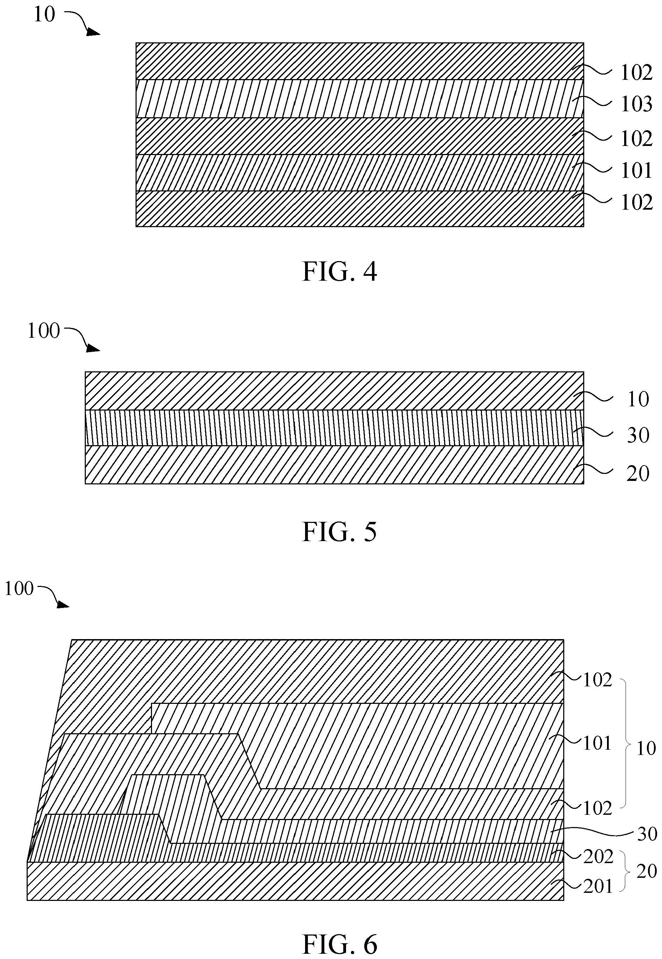

Referring to FIG. 4, FIG. 4 is a fourth schematic structural diagram of the package structure according to an embodiment of the present disclosure. The package structure 10 includes three inorganic layers 102, one organic structural layer 101, and an organic layer 103. The three inorganic layers 102, the organic structural layer 102, and the organic layer 103 are stacked in sequence in an order of one of the three inorganic layers, the organic structural layer, another one of the three inorganic layers, the organic layer, and yet another one of the three inorganic layers. A material of the organic layer 103 includes a UV-sensitive polymer, an epoxy polymer, or an acrylic polymer.

Specifically, the material of the organic layer 103 may be organic materials such as epoxy resin, polyimide (PI), polyethylene terephthalate (PET), polycarbonate (PC), polyethylene (PE), polyacrylate (PEA), or polymethylmethacrylate (PMMA).

The organic layer 103 is made of the organic materials. Combining the organic structural layer 101 and the organic layer 103 in the package structure 10 can better extend the intruding path of water vapor and effectively block water and oxygen. In addition, a surface of the organic layer 103 is flatter, so an interface quality between the inorganic layers 102 and the organic layer 103 can be improved, thereby effectively preventing the film layers from falling off.

Correspondingly, the present disclosure further provides the display panel. Referring to FIG. 5, FIG. 5 is a first schematic structural diagram of the display panel according to an embodiment of the present disclosure. The display panel 100 includes an array substrate 20, a light-emitting device layer 30, and the package structure 10. The light-emitting device layer 30 is disposed on the array substrate 20. The package structure 10 is disposed on one side of the light-emitting device layer 30 away from the array substrate 20. The package structure 10 is the package structure 10 mentioned above.

Specifically, referring to FIG. 6, FIG. 6 is a second schematic structural diagram of the display panel according to an embodiment of the present disclosure. Wherein, the array substrate 20 includes a substrate 201 and a thin film transistor layer 202. In addition, the package structure 10 including a stacked structure of an inorganic layer 102/ an organic structural layer 101/ an inorganic layer 102 in FIG. 5 is taken as an example for description. Thicknesses and shapes of each of film layers in FIG. 5 are only for illustration and do not cause a limitation on the structure of the display panel 100.

Wherein, the substrate 201 may be glass, functional glass (sensor glass), or a flexible substrate. Specific film layers and assembly thereof of the thin film transistor layer 202 are technical means commonly used in the art and will not be repeated here.

The display panel 100 provided in the present disclosure uses the package structure including the organic structural layer 101. The organic structural layer 101 includes the organic structural material. The organic structural material is the inorganic material having the chain chemical bonds. Due to having the chain chemical bonds, the inorganic material has related properties of organic materials. For example, the organic structural material has lower stresses and better step-coverage properties. The organic structural layer 101 of the present disclosure obtains the material having organic properties by the manufacturing method of inorganic materials. The organic structural layer 101 improves the water and oxygen blocking effect of the organic encapsulation materials. Therefore, the package structure 10 of the present disclosure can allow the display panel 100 to obtain the better encapsulation effect, thereby improving the encapsulation reliability of the display panel 100.

It should be noted that in addition to applying to encapsulation of the display panel 100, the package structure 10 provided in the present disclosure can also be applied to related aspects of step coverage of other electronic components. For example, it may be applied to electronic components having an undercut structure and used to cover steps formed due to the undercut structure.

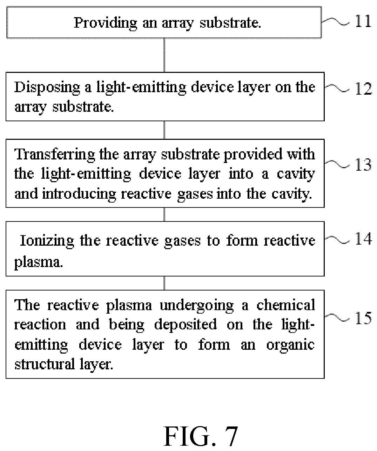

Correspondingly, the present disclosure further provides the manufacturing method of the display panel. Referring to FIG. 7, FIG. 7 is a flowchart of the manufacturing method of the display panel according to an embodiment of the present disclosure. The manufacturing method of the display panel specifically includes following steps.

Step 11: providing the array substrate.

Wherein, the array substrate may include the substrate and the thin film transistor layer disposed on the substrate. The substrate may be glass, functional glass (sensor glass), or the flexible substrate. Wherein, the functional glass is obtained by sputtering a transparent metal oxide conductive thin film on ultra-thin glass and annealing at a high temperature.

Providing glass, the functional glass, or the flexible substrate as the substrate, then the thin film transistor layer is manufactured on the substrate. A specific manufacturing method of the thin film transistor layer is technical means commonly used in the art and will not be repeated here.

Step 12: disposing the light-emitting device layer on the array substrate.

Step 13: transferring the array substrate provided with the light-emitting device layer into a cavity and introducing reactive gases into the cavity.

Wherein, the reactive gases include a silane gas (SiH₄) and a nitrous oxide gas (N₂O) or include the silane gas and ammonia (NH₃). Due to the need to react and generate the organic structural material, the reactive gases are partially ionized by increasing flow rates of the reactive gases that are introduced. Specifically, compared to flow rates of generating ordinary inorganic silicon nitride materials, silicon oxide materials, and silicon oxynitride materials, the gas flow rates will be increased by 3 to 7 times when used to generate the organic structural material. Increasing the flow rates of the reactive gases can partially ionize the reactive gases on one hand and can increase a film formation speed on another hand.

Step 14: ionizing the reactive gases to form reactive plasma.

Wherein, the reactive gases can be ionized by microwave or radio frequency. For example, adjusting a gas pressure and a radio frequency power in the cavity to ionize the reactive gases by radio frequency. Specifically, the gas pressure may range from 800 millitorr to 2000 millitorr. The radio frequency power may range from 1 KW to 2 KW.

Step 15: the reactive plasma undergoing a chemical reaction and being deposited on the light-emitting device layer to form the organic structural layer.
wherein, the material of the organic structural layer includes the organic structural material, and the organic structural material includes 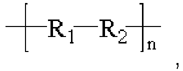 wherein, the R₁ group is 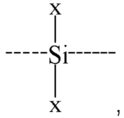 the R₂ group is one or more of 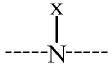 or -----O-----, n is a positive integer greater than or equal to 1, and x is one or more of -----H, ----SiH₃, or ---NH₂.

The present disclosure uses plasma enhanced chemical vapor deposition (PECVD) to manufacture the organic structural layer, so a manufacturing temperature is low, which will not affect the light-emitting device layer, thereby ensuring luminous efficiency of the light-emitting device layer. In addition, using the method of manufacturing inorganics to form the material having the organic properties can use the organic structural layer to replace film layers formed by the organic materials for encapsulation. It is not necessary to manufacture organic film layers by ink-jet printing, thereby preventing overflow of materials during ink-jet printing. In addition, the PECVD method has a fast deposition rate, and good film-forming quality, so the package structure formed has less micropores and less cracking, thereby ensuring a better encapsulation effect.

Optionally, after the step of disposing the light-emitting device layer on the array substrate, the method further includes a step of depositing the inorganic layer on one side of the light-emitting device layer away from the array substrate.

Wherein, the inorganic layer may be disposed on one side of the organic structural layer adjacent to the light-emitting device layer, or the inorganic layer may also be disposed on one side of the organic structural layer away from the light-emitting device layer. Or the inorganic layer may be disposed on both sides of the organic structural layer at a same time. The inorganic layer may be set in one layer or multiple layers.

The inorganic layer being disposed on the side of the organic structural layer adjacent to the light-emitting device layer is taken as an example for description. After disposing the light-emitting device layer on the array substrate, the inorganic layer is deposited on the light-emitting device layer by chemical vapor deposition (CVD), atomic layer deposition (ALD), or plasma enhanced chemical vapor deposition. For example, when the silicon nitride material is used as the inorganic layer, the array substrate provided with the light-emitting device layer is transferred to the cavity, and the silane gas and ammonia are introduced. After the two gas raw materials are introduced, the chemical reaction occurs between them to form silicon nitride, and silicon nitride is deposited on the light-emitting device layer and forms the inorganic layer. The inorganic layer manufactured by PECVD has a fast manufacture speed, a dense film layer, and good adhesion.

After manufacturing the inorganic layer, the organic structural layer can be subsequently manufactured by PECVD in a same cavity. In this way, there is no need to transfer the array substrate after the inorganic layer is manufactured, thereby preventing film layers from breaking during a transfer process and being able to speed up production.

Optionally, after the organic structural layer is manufactured, another inorganic layer may also be manufactured subsequently by PECVD in the same cavity, thereby forming a stacked package structure of an inorganic barrier/ an organic buffering layer/ an inorganic barrier.

When the silane gas and ammonia are used to manufacture the silicon nitride material of the inorganic layer, the organic structural layer may continue to be produced by the silane gas and ammonia. It can be manufactured only by increasing the gas flow rates to 3 to 7 times that of the inorganic layer and then ionized. In this way, the gases in the cavity are same, and other impurity will not be produced, so the package structure manufactured has high film purity and less defects, thereby being more beneficial to improve the encapsulation effect. Similarly, after the organic structural layer is manufactured, another silicon nitride inorganic layer can be manufactured by reducing the gas flow rates. In the above description, the introduction of silane gas and ammonia is used as an example. Correspondingly, for the production of other materials, please refer to this example. It can be understood that gases introduced when manufacturing the inorganic layer and the organic structural layer may also not be exactly the same.

Optionally, after the step of disposing the light-emitting device layer on the array substrate, the method further includes a step of depositing the organic layer on one side of the inorganic layer away from the array substrate.

Wherein, the organic layer may be disposed on one side of the inorganic layer adjacent to the light-emitting device layer, or the organic layer may also be disposed between the organic structural layer and the inorganic layer. Or the organic layer may be disposed between two inorganic layers. The organic layer may be set in one layer or multiple layers. Positions of the organic structural layer, the inorganic layer, and the organic layer are not limited in the present disclosure.

Specifically, the organic layer is manufactured by ink-jet printing or evaporation. A film-forming method of evaporation is simple, a film layer formed thereof is thin and has high purity and density. Film forming areas can be accurately controlled by ink-jet printing, thereby saving materials, reducing costs, and improving product yields.

The manufacturing method of the display panel provided in the present disclosure can manufacture the inorganic layer and the organic structural layer having the organic material properties in the same cavity by manufacturing the inorganic layer using CVD and manufacturing the organic structural layer using PECVD. The manufacturing method of the display panel can reduce transfer of the substrate during encapsulation, thereby preventing the package structure or the substrate from breaking during the transfer process and therefore improving product yields of the display panel.

The package structure, the display panel, and the manufacturing method of the display panel provided by the embodiments of the present disclosure are described in detail above. Specific examples are used herein to explain the principles and implementation of the present disclosure. The descriptions of the above embodiments are only used to help understand the method of the present disclosure and its core ideas; meanwhile, for those skilled in the art, the range of specific implementation and application may be changed according to the ideas of the present disclosure. In summary, the content of the specification should not be construed as causing limitations to the present disclosure.

## Claims

1. A package structure, comprising an organic structural layer, wherein a material of the organic structural layer comprises an organic structural material, and a structural formula of the organic structural material comprises 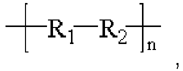 wherein an R₁ group is 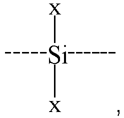 an R₂ group is one or more of 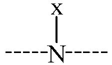 or -----O-----, n is a positive integer greater than or equal to 1, and x is one or more of -----H, ----SiH₃, or ---NH₂.

2. The package structure according to claim 1, wherein the material of the organic structural layer further comprises an inorganic material, the inorganic material comprises one or more combinations of silicon nitride, silicon oxide, or silicon oxynitride, and in the organic structural layer, a ratio of a content of the organic structural material to a content of the inorganic material ranges from 0.01 to 0.75.

3. The package structure according to claim 2, wherein the ratio of the content of the organic structural material to the content of the inorganic material ranges from 0.05 to 0.5.

4. The package structure according to claim 1, wherein a thickness of the organic structural layer ranges from 1 µm to 5 µm.

5. The package structure according to claim 1, further comprising at least one inorganic layer, wherein a material of the at least one inorganic layer comprises one or more combinations of nitride, oxide, or nitrogen oxide.

6. The package structure according to claim 5, wherein a thickness of the at least one inorganic layer ranges from 20 nm to 1500 nm.

7. The package structure according to claim 5, comprising two inorganic layers, wherein the organic structural layer is disposed between the two inorganic layers.

8. The package structure according to claim 5, comprising three inorganic layers and two organic structural layers, wherein the three inorganic layers and the two organic structural layers are stacked alternatingly.

9. The package structure according to claim 5, comprising three inorganic layers, the organic structural layer, and an organic layer, wherein the three inorganic layers, the organic structural layer, and the organic layer are stacked in sequence in an order of one of the three inorganic layers, the organic structural layer, another one of the three inorganic layers, the organic layer, and yet another one of the three inorganic layers, and a material of the organic layer comprises a UV-sensitive polymer, an epoxy polymer, or an acrylic polymer.

10. A display panel, comprising:
an array substrate;
a light-emitting device layer disposed on the array substrate; and
a package structure disposed on one side of the light-emitting device layer away from the array substrate and comprising an organic structural layer; wherein a material of the organic structural layer comprises an organic structural material, and a structural formula of the organic structural material comprises 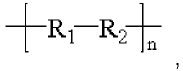 wherein an R₁ group is 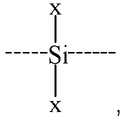 an R₂ group is one or more of 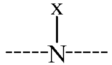 or -----O-----, n is a positive integer greater than or equal to 1, and x is one or more of -----H, ----SiH₃, or ---NH₂.

11. The display panel according to claim 10, wherein the material of the organic structural layer further comprises an inorganic material, the inorganic material comprises one or more combinations of silicon nitride, silicon oxide, or silicon oxynitride, and in the organic structural layer, a ratio of a content of the organic structural material to a content of the inorganic material ranges from 0.01 to 0.75.

12. The display panel according to claim 10, wherein a thickness of the organic structural layer ranges from 1 µm to 5 µm.

13. The display panel according to claim 10, wherein the package structure further comprises at least one inorganic layer, and a material of the at least one inorganic layer comprises one or more combinations of nitride, oxide, or nitrogen oxide.

14. The display panel according to claim 13, wherein a thickness of the at least one inorganic layer ranges from 20 nm to 1500 nm.

15. The display panel according to claim 13, wherein the package structure comprises two inorganic layers, and the organic structural layer is disposed between the two inorganic layers.

16. The display panel according to claim 13, wherein the package structure comprises three inorganic layers and two organic structural layers, and the three inorganic layers and the two organic structural layers are stacked alternatingly.

17. The display panel according to claim 13, wherein the package structure comprises three inorganic layers, the organic structural layer, and an organic layer, the three inorganic layers, the organic structural layer, and the organic layer are stacked in sequence in an order of one of the three inorganic layers, the organic structural layer, another one of the three inorganic layers, the organic layer, and yet another one of the three inorganic layers, and a material of the organic layer comprises a UV-sensitive polymer, an epoxy polymer, or an acrylic polymer.

18. A manufacturing method of a display panel, comprising following steps:
providing an array substrate;
disposing a light-emitting device layer on the array substrate;
transferring the array substrate provided with the light-emitting device layer into a cavity and introducing reactive gases into the cavity, wherein the reactive gases comprise a silane gas and a nitrous oxide gas, or comprise the silane gas and ammonia;
ionizing the reactive gases to form reactive plasma; and
the reactive plasma undergoing a chemical reaction and being deposited on the light-emitting device layer to form an organic structural layer; wherein a material of the organic structural layer comprises an organic structural material, and a structural formula of the organic structural material comprises 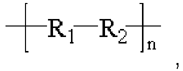 wherein an R₁ group is 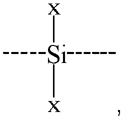 an R₂ group is one or more of 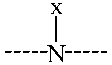 or -----O-----, n is a positive integer greater than or equal to 1, and x is one or more of -----H, ----SiH₃, or ---NH₂.

19. The manufacturing method of the display panel according to claim 18, wherein after the step of disposing the light-emitting device layer on the array substrate, the method further comprises a step of depositing an inorganic layer on one side of the light-emitting device layer away from the array substrate.

20. The manufacturing method of the display panel according to claim 19, wherein after the step of disposing the light-emitting device layer on the array substrate, the method further comprises a step of depositing an organic layer on one side of the inorganic layer away from the array substrate.
